# FASCICULE DE BREVET EUROPEEN

(11) **EP 3 061 137 B1**
(45) Date de publication et mention de la délivrance du brevet: **20.03.2019**
(21) Numéro de dépôt: 14795976.1
(22) Date de dépôt: 24.10.2014
(51) Int. Cl.: H01L 33/06, H01L 33/32, H01L 33/18, H01L 25/16

(54) **DISPOSITIF EMISSIF LUMINEUX**
LICHTEMITTIERENDE VORRICHTUNG
LIGHT EMITTING DEVICE

(30) Priorité: 25.10.2013 FR 1360420
(43) Date de publication de la demande: 31.08.2016
(73) Titulaire: Commissariat à l'Énergie Atomique et aux Énergies Alternatives, 75015 Paris (FR)
(72) Inventeur: ROBIN, Ivan-Christophe, F-38000 Grenoble (FR); BONO, Hubert, F-38000 Grenoble (FR)
(74) Mandataire: Brevalex
(86) Numéro de dépôt international: PCT/EP2014/072900
(87) Numéro de publication internationale: WO 2015/059296

(56) Documents cités:
- WO-A2-2013/009552
- CN-A- 102 122 689
- JP-A- 2008 034 887
- US-A1- 2005 168 564

## Description

### DOMAINE TECHNIQUE ET ART ANTÉRIEUR

L'invention concerne le domaine des diodes électroluminescentes (appelées DELs ou LEDs), ainsi que celui des dispositifs émissifs lumineux à base de telles LEDs (écrans, projecteurs, murs d'images, etc.).

L'invention s'applique notamment à la réalisation de LEDs à multiples puits quantiques (MQW, ou « Multiple Quantum Wells ») réalisant des émissions lumineuses homogènes en termes d'intensité et dans des gammes de longueurs d'ondes différentes les uns par rapport aux autres. L'invention s'applique avantageusement à la réalisation de LEDs émettant une lumière blanche, c'est-à-dire un mélange sensiblement homogène de longueurs d'ondes correspondant aux couleurs rouge, vert et bleu.

Les matériaux à base de GaN, tels que le GaN, l'InGaN, ou l'AlGaN, sont utilisés pour réaliser des LEDs émettant dans des gammes de longueurs d'ondes correspondant à l'UV (Ultra-Violet), le bleu, le vert, voire le rouge lorsque ces LEDs sont réalisées avec une géométrie de nanofils. En effet, l'énergie de bande interdite du GaN, qui est égale à 3,42 eV à température ambiante, permet d'obtenir une émission dans l'UV. En ajoutant de l'indium au GaN pour former de l'InGaN, l'énergie de la bande interdite du matériau est abaissée, ce qui permet de décaler les longueurs d'ondes d'émission dans le domaine visible. Une LED émettant une lumière bleue est par exemple obtenue en réalisant des puits quantiques d'InGaN dans lesquels la composition en indium est comprise entre 5 % et 20%, cette composition en indium dans les couches émissives des puits quantiques étant supérieure à celle du matériau des couches barrières disposées entre les puits quantiques.

La technique utilisée actuellement pour fabriquer des LEDs à base de semi-conducteurs tels que le GaN consiste à réaliser une jonction p-n, c'est-à-dire mettre en contact électriquement un semi-conducteur dopé p avec un semi-conducteur dopé n, avec, entre ces semi-conducteurs dopés p et n, une région intrinsèque, c'est-à-dire non intentionnellement dopée, comprenant notamment des puits quantiques. Une zone de déplétion est alors obtenue au niveau de la jonction, et notamment au niveau des puits quantiques. En faisant passer un courant électrique dans cette structure, des recombinaisons radiatives de charges (électrons et trous) sont alors obtenues au niveau de la zone de déplétion, entrainant une émission lumineuse depuis les puits quantiques. Les puits quantiques correspondent par exemple à des couches d'InGaN d'épaisseur comprise entre 0,5 nm et 10 nm et comprenant des compositions d'indium comprises entre 5 % et 30 %. Ceci permet de localiser les charges dans ces puits quantiques pour augmenter l'efficacité d'émission radiative et éviter aux charges d'être perdues sur des défauts non radiatifs.

Le document US 2009/0078955 A1 décrit un dispositif émissif lumineux comportant, pour chaque pixel, trois LEDs superposées émettant chacune dans l'une des gammes de longueurs d'ondes correspondant aux couleurs rouge, vert et bleu. Un tel dispositif émissif lumineux permet donc de réaliser une émission de lumière blanche en faisant émettre, depuis chacune des LED d'un pixel, des lumières rouge, verte et bleue d'intensités similaires. Toutefois, la réalisation d'un tel dispositif est complexe et couteuse car l'empilement de trois jonctions p-n dans chaque pixel implique de réaliser des connexions électriques pour chacune de ces jonctions afin de commander l'émission lumineuse de chacune des LED. Un tel dispositif pose également des problèmes d'encombrement en raison notamment des connexions électriques nécessaires.

Le document US 2012/0223289 A1 décrit un dispositif émissif lumineux comportant, dans chaque pixel, des sous-pixels formés d'une ou plusieurs LEDs destinées à émettre des lumières rouge, verte et bleue afin d'obtenir globalement, au niveau du pixel, une émission de lumière blanche. Les LEDs sont ici réalisées sous la forme de nanofils disposés les uns à côté des autres. Les mêmes problèmes de coût, de complexité et d'encombrement que ceux exposés précédemment se posent aussi pour ce type de dispositif.

Le document WO 2013/009552 A2 décrit une LED comprenant des jonctions p-n à base d'InGaN. Bien qu'une telle LED puisse émettre une lumière de différentes couleurs, l'ajustement de la longueur d'onde émise par une telle LED n'est pas aisé et cette longueur d'onde émise a tendance à rester centrée sur la couleur verte.

### EXPOSÉ DE L'INVENTION

Un but de la présente invention est de proposer un dispositif émissif lumineux comportant une diode électroluminescente, ou LED, à multiples puits quantiques dans laquelle les émissions lumineuses des puits quantiques sont sensiblement homogènes, en termes d'intensité lumineuse, les unes par rapport aux autres, et permettant d'ajuster aisément la couleur émise par la LED parmi toutes celles du spectre visible ou du blanc.

Pour cela, la présente invention propose un dispositif émissif lumineux comportant au moins :
- une diode électroluminescente comportant au moins une couche d'In_{Xn}Ga_{(1-Xn)}N dopé n et une couche de GaN dopé p formant ensemble une jonction p-n, et une zone active disposée entre la couche d'In_{Xn}Ga_{(1-Xn)}N dopé n et la couche de GaN dopé p et comprenant m couches émissives d'In_{Yi}Ga_{(1-Yi)}N chacune disposée entre deux couches barrières d'In_{Zj}Ga_{(1-Zj)}N qui sont en contact avec ladite couche émissive au niveau de deux faces opposées de ladite couche émissive, dans laquelle :
   - pour i compris entre 1 et m-1, les compositions en indium des couches émissives sont telles que Y(i+1) < Yi, la (i+1)^{ème} couche émissive étant disposée entre la (i)^{ème} couche émissive et la couche de GaN dopé p ;
   - pour j compris entre 1 et m, les compositions en indium des couches barrières sont telles que Z(j+1) < Zj, la (j+1)^{ème} couche barrière étant disposée entre la (j)^{ème} couche barrière et la couche de GaN dopé p ;
   - pour i = j, les compositions en indium des couches émissives et des couches barrières sont telles que Zj < Yi et Z(j+1) < Yi ;
      avec m : nombre entier supérieur ou égal à 2 ;
      i : nombre entier compris entre 1 et m ;
      j : nombre entier compris entre 1 et (m+1) ;
- une alimentation électrique apte à alimenter électriquement la diode électroluminescente par un signal périodique,
- un dispositif de commande de l'alimentation électrique apte à modifier une valeur crête du signal périodique en fonction d'au moins un spectre de la lumière destinée à être émise par la diode électroluminescente.

Il est également décrit une diode électroluminescente comportant au moins une couche d'In_{Xn}Ga_{(1-Xn)}N dopé n et une couche de GaN dopé p formant ensemble une jonction p-n, et une zone active disposée entre la couche d'In_{Xn}Ga_{(1-Xn)}N dopé n et la couche de GaN dopé p et comprenant m couches émissives d'In_{Yi}Ga_{(1-Yi)}N chacune disposée entre deux couches barrières d'In_{Zj}Ga_{(1-Zj)}N qui sont en contact avec ladite couche émissive au niveau de deux faces opposées de ladite couche émissive, dans laquelle :
- pour i compris entre 1 et m-1, les compositions en indium des couches émissives sont telles que Y(i+1) < Yi, la (i+1)^{ème} couche émissive étant disposée entre la (i)^{ème} couche émissive et la couche de GaN dopé p ;
- pour j compris entre 1 et m, les compositions en indium des couches barrières sont telles que Z(j+1) < Zj, la (j+1)^{ème} couche barrière étant disposée entre la (j)^{ème} couche barrière et la couche de GaN dopé p ;
- pour i = j, les compositions en indium des couches émissives et des couches barrières sont telles que Zj < Yi et Z(j+1) < Yi ;
   avec m : nombre entier supérieur ou égal à 2 ;
   i : nombre entier compris entre 1 et m ;
   j : nombre entier compris entre 1 et (m+1).

La diode électroluminescente comporte donc m couches émissives, formant m puits quantiques, dont les compositions en indium sont différentes les unes par rapport aux autres et sont plus importantes du côté de la couche d'In_{Xn}Ga_{(1-Xn)}N dopé n que du côté de la couche de GaN dopé p. Ces puits quantiques réalisent donc des émissions lumineuses dans des gammes de longueurs d'ondes différentes et pouvant couvrir notamment l'intégralité du spectre visible. De plus, compte tenu des couches barrières entre lesquelles les couches émissives sont disposées et qui comportent elles aussi des compositions en indium différentes les unes par rapport au autres et qui sont plus importantes du côté de la couche d'In_{Xn}Ga_{(1-Xn)}N dopé n que du côté de la couche de GaN dopé p, les émissions lumineuses réalisées par les puits quantiques sont sensiblement homogènes les unes par rapport aux autres en termes d'intensité lumineuse.

Le spectre lumineux global émis par la diode électroluminescente peut donc être facilement ajusté via le choix des compositions d'indium des couches émissives, les compositions d'indium des couches barrières étant choisies en fonction des compositions d'indium des couches émissives.

De plus, avec de telles couches barrières, une tension de seuil destinée à être appliquée aux bornes de la diode électroluminescente pour une densité de courant donnée traversant la diode électroluminescente est inférieure à celle nécessaire pour obtenir une même densité de courant dans une diode électroluminescente qui comporterait des couches barrières en GaN.

De plus, avec une telle diode électroluminescente, le spectre lumineux global émis par la diode électroluminescente peut être facilement ajusté en choisissant judicieusement les paramètres d'un signal périodique alimentant électriquement la diode électroluminescente tels que la valeur crête et le rapport cyclique de ce signal périodique. L'ajustement des paramètres du signal d'alimentation permet de faire varier la densité de courant dans la diode électroluminescente, ce qui modifie le taux d'émission d'un puits à l'autre au sein de la diode, permettant donc de contrôler le spectre de la lumière émise, c'est-à-dire la couleur de la lumière émise.

Les couches barrières peuvent avoir chacune une épaisseur comprise entre environ 1 nm et 25 nm, et/ou la première couche barrière d'In_{Z1}Ga_{(1-Z1)}N peut avoir une épaisseur supérieure ou égale à 2 nm.

Les compositions en indium Yi et/ou Zj sont telles que :
pour i = j : 0,15.Yi < Zj < 0,9.Yi, et/ou
pour j compris entre 1 et m : 0,25.Zj < Z(j+1) < 0,9.Zj.

Le nombre m de couches émissives peut être égal à 3, la première couche émissive pouvant être apte à réaliser une émission lumineuse dans la gamme des longueurs d'ondes de la couleur rouge, la deuxième couche émissive pouvant être apte à réaliser une émission lumineuse dans la gamme des longueurs d'ondes de la couleur verte, et la troisième couche émissive pouvant être apte à réaliser une émission lumineuse dans la gamme des longueurs d'ondes de la couleur bleue. Ainsi, compte tenu de l'homogénéité des émissions lumineuses réalisées par les couches émissives, la diode électroluminescente réalise une émission lumineuse de couleur blanche.

Le nombre m de couches émissives peut être égal à 3, et Y1 peut être égale à environ 0,4, et/ou Y2 peut être égale à environ 0,25, et/ou Y3 peut être égale à environ 0,15, et/ou Z1 peut être égale à environ 0,12, et/ou Z2 peut être égale à environ 0,09, et/ou Z3 peut être égale à environ 0,07, et/ou Z4 peut être égale à environ 0,05.

Avec de telles compositions en indium, la diode électroluminescente réalise une émission lumineuse de couleur blanche.

La composition en indium Xn peut être comprise entre 0 et environ 0,3, et/ou la composition en indium Xn peut varier entre une première valeur Xnₐ et une deuxième valeur Xn_{b} supérieure à la première valeur Xnₐ selon une direction sensiblement perpendiculaire à une première face de la couche d'In_{Xn}Ga_{(1-Xn)}N dopé n en regard de laquelle la première couche émissive est disposée, et la composition en indium au niveau de la première face de la couche d'In_{Xn}Ga_{(1-Xn)}N dopé n peut être égale à Xn_{b} et la composition en indium au niveau d'une deuxième face de la couche d'In_{Xn}Ga_{(1-Xn)}N dopé n, opposée à la première face, peut être égale à Xnₐ.

Dans ce cas, Xnₐ peut être égale à 0, et Xn_{b} peut être supérieure à 0 et inférieure ou égale à environ 0,3.

La composition en indium Zj dans chacune des couches barrières peut varier entre une première valeur Zjₐ et une deuxième valeur Zj_{b} supérieure à la première valeur Zjₐ selon une direction sensiblement perpendiculaire à une face de ladite couche barrière contre laquelle l'une des couches émissives est disposée, la composition en indium au niveau d'une première face de ladite couche barrière se trouvant du côté de la couche d'In_{Xn}Ga_{(1-Xn)}N dopé n pouvant être égale à Zj_{b}, la composition en indium au niveau d'une deuxième face de ladite couche barrière, opposée à ladite première face et se trouvant du côté de la couche de GaN dopé p pouvant être égale à Zjₐ.

Dans ce cas, les compositions en indium Zj dans chacune des couches barrières peuvent avantageusement être telles que Zjₐ > Z(j+1)_{b} et/ou, pour chacune des couches barrières, la différence entre la première valeur Zjₐ et la deuxième valeur Zj_{b} peut être inférieure ou égale à environ 0,3.

La diode électroluminescente est avantageusement utilisée pour réaliser des dispositifs d'affichage lumineux tels que des micro-afficheurs ou des micro-projecteurs, du fait qu'une telle diode électroluminescente offre la possibilité de réaliser des dispositifs d'affichage avec des pixels accordables en longueurs d'ondes grâce au choix des paramètres du signal périodique alimentant électriquement la diode électroluminescente.

Le signal périodique peut comporter un rapport cyclique α, et le dispositif de commande de l'alimentation électrique peut être apte à modifier le rapport cyclique α du signal périodique en fonction d'une valeur de l'intensité de la lumière destinée à être émise par la diode électroluminescente.

Le rapport cyclique α peut être tel que *α* ∈ ]0;1].

L'alimentation électrique peut être une alimentation électrique à découpage.

Le dispositif émissif lumineux peut comporter en outre un dispositif de détection d'un spectre et/ou d'une intensité d'une lumière destinée à être émise par la diode électroluminescente, et le dispositif de commande de l'alimentation électrique peut être apte à modifier la valeur crête et/ou le rapport cyclique α du signal périodique respectivement en fonction des valeurs du spectre et de l'intensité de la lumière destinée à être détectées et en fonction de valeurs cibles du spectre et de l'intensité.

L'invention concerne également un procédé de réalisation d'un dispositif émissif lumineux selon l'invention, dans lequel les couches de la diode électroluminescente sont des couches planaires réalisées par croissance les unes au-dessus des autres, ou dans lequel les couches de la diode électroluminescente sont réalisées par croissance sous la forme de nanofils radiaux ou axiaux.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement une diode électroluminescente d'un dispositif émissif lumineux, objet de la présente invention, selon un mode de réalisation particulier ;
- la figure 2 représente les gaps dans différentes couches d'une diode électroluminescente comportant des couches barrières en GaN ;
- la figure 3 représente le taux de recombinaisons radiatives obtenu dans les couches d'une diode électroluminescente comportant des couches barrières en GaN ;
- la figure 4 représente les concentrations en électrons et en trous obtenues dans les couches d'une diode électroluminescente comportant des couches barrières en GaN ;
- la figure 5 représente les gaps dans les couches de la diode électroluminescente du dispositif émissif lumineux, objet de la présente invention, selon le mode de réalisation particulier représenté sur la figure 1 ;
- la figure 6 représente le taux de recombinaisons radiatives obtenu dans les couches de la diode électroluminescente du dispositif émissif lumineux, objet de la présente invention, selon le mode de réalisation particulier représenté sur la figure 1 ;
- la figure 7 représente les concentrations en électrons et en trous obtenues dans les couches de la diode électroluminescente du dispositif émissif lumineux, objet de la présente invention, selon le mode de réalisation particulier représenté sur la figure 1 ;
- les figures 8A à 8D représentent les taux de recombinaisons radiatives obtenus dans les couches de la diode électroluminescente du dispositif émissif lumineux, objet de la présente invention et selon le mode de réalisation particulier représenté sur la figure 1, pour différentes valeurs de la densité de courant dans la diode électroluminescente ;
- la figure 9 représente l'intensité relative de la lumière émise par la diode électroluminescente du dispositif émissif lumineux, objet de la présente invention et selon le mode de réalisation particulier représenté sur la figure 1, pour différentes valeurs de la densité de courant dans la diode électroluminescente, en fonction de la longueur d'onde ;
- la figure 10 représente schématiquement un signal d'alimentation électrique de la diode électroluminescente du dispositif émissif lumineux, objet de la présente invention ;
- les figures 11A et 11B représentent schématiquement des diodes électroluminescentes de dispositifs émissifs lumineux, objets de la présente invention, réalisées sous la forme de nanofils ;
- la figure 12 représente schématiquement un dispositif émissif lumineux, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

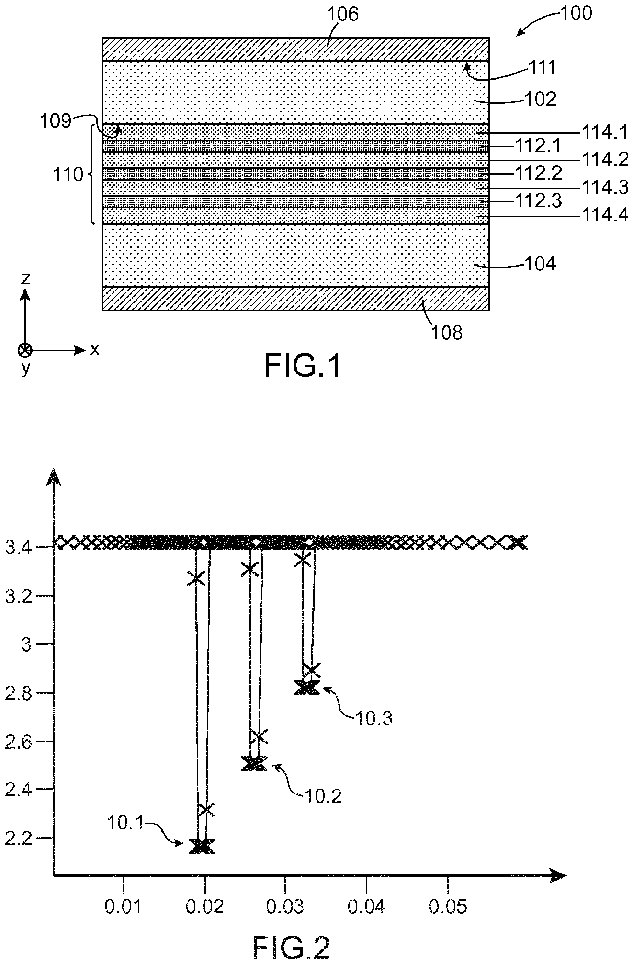

On se réfère tout d'abord à la figure 1 qui représente une diode électroluminescente, ou LED, 100 selon un mode de réalisation particulier.

La LED 100 comporte une jonction p-n formée par une couche d'In_{Xn}Ga_{(1-Xn)}N dopé n 102 et une couche de GaN dopé p (GaN-p) 104. La couche 102 comprend du GaN dopé n (GaN-n) ou de l'InGaN dopé n (InGaN-n) selon la valeur de la composition en indium Xn qui est par exemple comprise entre 0,05 et 0,35. La couche 102 est dopée n avec une concentration de donneurs comprise entre environ 10¹⁷ et 5.10¹⁹ donneurs/cm³. La couche 104 comprend du GaN-p avec une concentration d'accepteurs comprise entre environ 10¹⁷ et 5.10¹⁹ donneurs/cm³. Ces deux couches 102 et 104 ont par exemple chacune une épaisseur (dimension selon l'axe Z représenté sur la figure 1) comprise entre environ 20 nm et 10 µm. Une première électrode métallique 106 est disposée contre la couche dopée n 102 et forme une cathode de la LED 100, et une deuxième électrode métallique 108 est disposée contre la couche dopée p 104 et forme une anode de la LED 100.

La LED 100 comporte, entre les couches 102 et 104, une zone active 110 comprenant m couches émissives 112 d'InGaN, m étant un nombre entier supérieur ou égal à 2. La zone active 110 est disposée contre une première face 109 de la couche dopée n 102, opposée à une deuxième face 111 de la couche dopée n 102 contre laquelle la première électrode métallique 106 est disposée. La LED 100 décrite ici comporte trois couches émissives 112, référencées 112.1, 112.2 et 112.3, formant chacune un puits quantique. L'épaisseur de chacune des couches émissives 112 est par exemple comprise entre environ 0,5 et 10 nm. La zone active 110 comporte également m+1 couches barrières 114 d'InGaN telles que chaque couche émissive 112 soit disposée entre deux couches barrières 114, et donc que la zone active 110 soit formée d'un empilement alterné de m couches émissives 112 et de m+1 couches barrières 114.

La LED 100 décrite ici comporte quatre couches barrières 114, référencées 114.1, 114.2, 114.3 et 114.4, telles que la première couche émissive 112.1 soit disposée entre la première couche barrière 114.1 et la deuxième couche barrière 114.2, que la deuxième couche émissive 112.2 soit disposée entre la deuxième couche barrière 114.2 et la troisième couche barrière 114.3, et que la troisième couche émissive 112.3 soit disposée entre la troisième couche barrière 114.3 et la quatrième couche barrière 114.4. La première couche barrière 114.1 est disposée contre la couche dopée n 102 et la dernière couche barrière 114.4 (ou 114.(m+1) pour le cas général de m couches émissives) est disposée contre la couche dopée p 104. En variante, une couche tampon d'InGaN d'épaisseur supérieure à celle de la première couche barrière 114.1 pourrait être interposée entre la première couche barrière 114.1 et la couche dopée n 102.

Dans ce cas, la composition en indium de cette couche tampon est supérieure ou égale à celle du matériau de la première couche barrière 114.1. De plus, la couche dopée n 102 peut dans ce cas ne pas comporter d'indium et être par exemple à base de GaN. L'épaisseur de chacune des couches barrières 114 est par exemple comprise entre environ 1 nm et 25 nm. De plus, l'épaisseur de la première couche barrière 114.1 disposée contre la couche dopée n 102 est de préférence supérieure ou égale à environ 2 nm.

Toutes les couches de la zone active 110 de la LED 100, c'est-à-dire les couches émissives 112 et les couches barrières 114, comportent des matériaux non intentionnellement dopés (de concentration en donneurs résiduels n_{nid} égale à environ 10¹⁷ donneurs/cm⁻³, ou comprise entre environ 10¹⁵ et 10¹⁸ donneurs/cm³).

Chacune des couches émissives 112 de la LED 100 est ici destinée à réaliser une émission lumineuse dans une gamme de longueurs d'ondes différentes de celles émises par les autres couches émissives 112 de la LED 100. Pour cela, la composition en indium du matériau de chaque couche émissive 112 est différente de celles des matériaux des autres couches émissives 112. En considérant que la (i)^{ème} couche émissive 112.i comporte de l'In_{Yi}Ga_{(1-Yi)}N, pour i compris entre 1 et m-1, les compositions en indium Yi dans les couches émissives 112 sont telles que Y(i+1) < Yi, la (i+1)^{ème} couche émissive 112.(i+1) étant disposée entre la (i)^{ème} couche émissive 112.i et la couche dopée p 104.

Ainsi, la couche émissive 112 comportant la plus grande composition en indium est la première couche émissive 112.1 qui se trouve du côté de la couche dopée n 102, et celle comportant la plus petite composition en indium est la dernière couche émissive 112.m qui se trouve du côté de la couche dopée p 104, c'est-à-dire la troisième couche émissive 112.3 sur l'exemple de la figure 1. Les compositions en indium dans les différentes couches émissives 112 diminuent les unes par rapport aux autres dans le sens allant de la couche dopée n 102 à la couche dopée p 104.

Les valeurs des compositions en indium dans les différentes couches émissives 112 sont adaptées en fonction de la colorimétrie souhaitée, c'est-à-dire du spectre d'émission émis souhaité pour chacun des puits quantiques de la LED 100. Dans l'exemple de la figure 1, la première couche émissive 112.1 est destinée à réaliser une émission lumineuse dans la gamme des longueurs d'ondes de la couleur rouge, par exemple à une longueur d'onde égale à environ 600 nm, la deuxième couche émissive 112.2 est destinée à réaliser une émission lumineuse dans la gamme des longueurs d'ondes de la couleur verte, par exemple à une longueur d'onde égale à environ 500 nm, et la troisième couche émissive 112.3 est destinée à réaliser une émission lumineuse dans la gamme des longueurs d'ondes de la couleur bleue, par exemple à une longueur d'onde égale à environ 430 nm. Pour réaliser ces émissions lumineuses, la composition en indium Y1 de l'In_{Y1}Ga_{(1-Y1)}N de la première couche émissive 112.1 est égale à environ 40 %, la composition en indium Y2 de l'In_{Y2}Ga_{(1-Y2)}N de la deuxième couche émissive 112.2 est égale à environ 25 %, et la composition en indium Y3 de l'In_{Y3}Ga_{(1-Y3)}N de la troisième couche émissive 112.3 est égale à environ 15 %.

Dans la LED 100, les émissions lumineuses réalisées par les différents puits quantiques de la zone active 110 sont homogènes en termes d'intensité lumineuse. Ainsi, pour que la LED 100 de la figure 1 réalise une émission lumineuse de couleur blanche, les trois puits quantiques de la LED 100 sont réalisés tels que les intensités de leurs émissions lumineuses soient homogènes les unes par rapport aux autres. Cette homogénéité des émissions lumineuses des différents puits quantiques de la LED 100 est obtenue en choisissant judicieusement les compositions en indium des matériaux des couches barrières 114. En considérant que la (j)^{ème} couche barrière 114.j comporte de l'In_{Zj}Ga_{(1-Zj)}N, pour j compris entre 1 et m, les compositions en indium dans les couches barrières 114 sont telles que Z(j+1) < Zj, la (j+1)^{ème} couche barrière 114.(j+1) étant disposée entre la (j)^{ème} couche barrière 114.j et la couche dopée p 104. Ainsi, la couche barrière 114 comportant la plus grande composition en indium est la première couche barrière 114.1 qui est disposée du côté de la couche dopée n 102, et celle comportant la plus petite composition en indium (cette composition en indium pouvant être nulle) est la dernière couche barrière 114.(m+1) se trouvant du côté de la couche dopée p 104, c'est-à-dire la quatrième couche barrière 114.4 sur l'exemple de la figure 1. Les compositions en indium dans les différentes couches barrières 114 diminuent les unes par rapport aux autres dans le sens allant de la couche dopée n 102 à la couche dopée p 104.

Dans l'exemple décrit ci-dessus, la couche dopée p 104 comporte du GaN. En variante, la couche dopée p 104 peut comporter de l'InGaN. Dans ce cas, la composition en indium de l'InGaN de la couche dopée p 104 est inférieure ou égale à celle du matériau de la dernière couche barrière 114.(m+1).

Les valeurs des compositions en indium de l'InGaN des couches barrières 114 sont adaptées notamment en fonction des valeurs des compositions en indium de l'InGaN des couches émissives 112. Ainsi, pour i = j, la composition en indium dans la (i)^{ème} couche émissive 112.i, la composition en indium dans la (j)^{ème} couche barrière 114.j et la composition en indium dans la (j+1)^{ème} couche barrière 114.(j+1) sont telles que Zj < Yi et Z(j+1) < Yi, et particulièrement telles que 0,15.Yi < Zj < 0,9.Yi, et de préférence telles que 0,25.Yi < Zj < 0,5.Yi. De plus, les valeurs des compositions en indium de l'InGaN des couches barrières 114 peuvent être choisies les unes en fonction des autres. Ainsi, pour j compris entre 1 et m, les compositions en indium dans les couches barrières 114 sont telles que 0,25.Zj < Z(j+1) < 0,9.Zj, et de préférence telles que 0,5.Zj < Z(j+1) < 0,9.Zj, ou encore telles que 0,7.Zj < Z(j+1) < 0,8.Zj et par exemple telles que Z(j+1) soit égale à environ 0,75.Zj. En outre, la composition en indium de la première couche barrière 114.1 peut être similaire à celle de la couche dopée n 102.

Dans l'exemple décrit ici, compte tenu des émissions lumineuses souhaitées pour les différents puits quantiques de la LED 100, la composition en indium Z1 de l'In_{Z1}Ga_{(1-Z1)}N de la première couche barrière 114.1 est égale à environ 12 % (et égale à celle de la couche dopée n 102), la composition en indium Z2 de l'In_{Z2}Ga_{(1-Z2)}N de la deuxième couche barrière 114.2 est égale à environ 9 %, la composition en indium Z3 de l'In_{Z3}Ga_{(1-Z3)}N de la troisième couche barrière 114.3 est égale à environ 7 %, et la composition en indium Z4 de l'In_{Z4}Ga_{(1-Z4)}N de la quatrième couche barrière 114.4 est égale à environ 5 %.

La valeur de la tension appliquée aux bornes des électrodes métalliques 106 et 108 de la LED 100 est fonction de la densité de courant recherchée dans la LED. Cette densité de courant est de préférence comprise entre environ 60 et 90 A/cm² afin de conserver une très bonne homogénéité d'émission entre les différents puits quantiques de la LED 100.

Afin d'illustrer l'homogénéité des émissions lumineuses des différents puits quantiques de la LED 100 obtenue grâce à de telles couches barrières, les performances obtenues avec la LED 100 décrite ci-dessus sont comparées avec celles d'une autre LED comprenant des couches 102, 104, 106, 108 et 112 identiques à celles de la LED, mais comportant des couches barrières réalisées en GaN et non en InGaN comme dans la LED 100. La couche dopée n de cette autre LED comporte également du GaN. Les différentes simulations décrites ci-dessous sont réalisées avec le logiciel de simulation SILVACO® d'ATLAS®.

La figure 2 représente les gaps obtenus au sein des différentes couches de cette autre LED. Trois « creux » référencés 10.1, 10.2 et 10.3 correspondent aux gaps dans les trois couches émissives de cette autre LED.

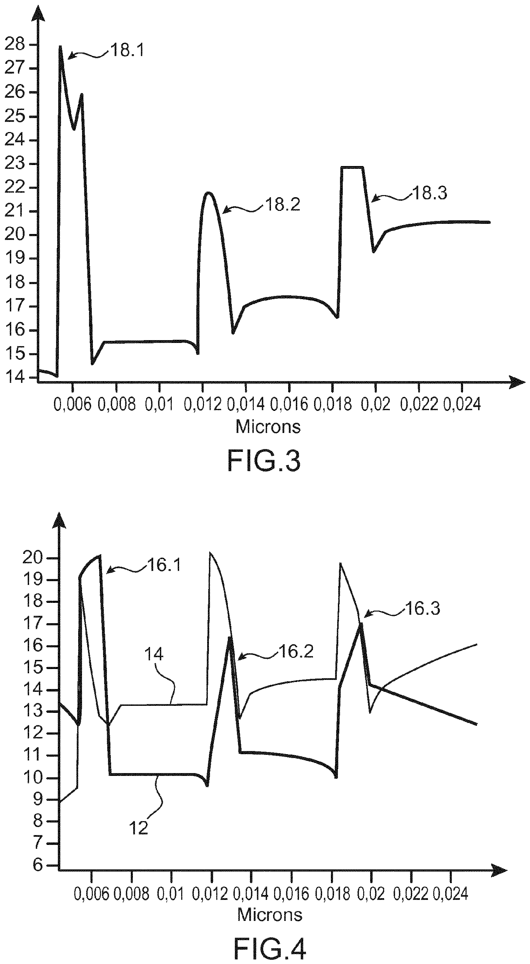

La figure 3 représente le taux de recombinaisons radiatives, en échelle logarithmique et par cm³.s, obtenu dans les couches de cette autre LED, pour une densité de courant d'environ 60 A/cm² obtenue avec une tension de seuil d'environ 5,2 V appliquée entre l'anode et la cathode de cette autre LED. Ce taux de recombinaisons radiatives est fonction notamment des concentrations d'électrons et de trous au sein des couches de cette autre LED. La figure 4 représente les concentrations en électrons (représentée par la courbe 12) et en trous (représentée par la courbe 14), par cm³, obtenues dans les différentes couches de cette autre LED polarisée comme précédemment avec une tension d'environ 5,2 V.

La courbe 14 représentée sur la figure 4 comporte trois pics de valeurs comprises entre environ 10¹⁹ et 10²⁰ trous/cm³, correspondant aux concentrations de trous présents dans les trois couches émissives d'InGaN de cette autre LED. La répartition des trous dans les couches émissives de cette autre LED est donc relativement homogène. La courbe 12 représentée sur la figure 4 présente également trois pics correspondant aux concentrations d'électrons dans les trois couches émissives de cette autre LED. Par contre, le premier pic de la courbe 12, référencé 16.1 et correspondant à la concentration en électrons dans la première couche émissive de cette autre LED destinée à émettre dans la gamme des longueurs d'ondes de la couleur rouge, est beaucoup plus important (d'environ 3 à 4 ordres de grandeur) que les deux autres pics de la courbe 12, référencés 16.2 et 16.3 et correspondant aux concentrations en électrons respectivement dans la deuxième et troisième couches émissives destinées à émettre dans les gammes des longueurs d'ondes des couleurs vert et bleu. Cela se traduit sur la figure 3 par un taux de recombinaisons radiatives beaucoup plus important dans la première couche émissive (pic référencé 18.1, correspondant à l'émission de rouge) que dans la deuxième couche émissive (pic référencé 18.2, correspondant à l'émission de vert) et dans la troisième couche émissive (pic référencé 18.3, correspondant à l'émission de bleu).

On voit donc que cette autre LED a une émission lumineuse tendant nettement vers le rouge en raison de l'inhomogénéité d'émission, en termes d'intensité lumineuse, des différents puits quantiques de cette autre LED.

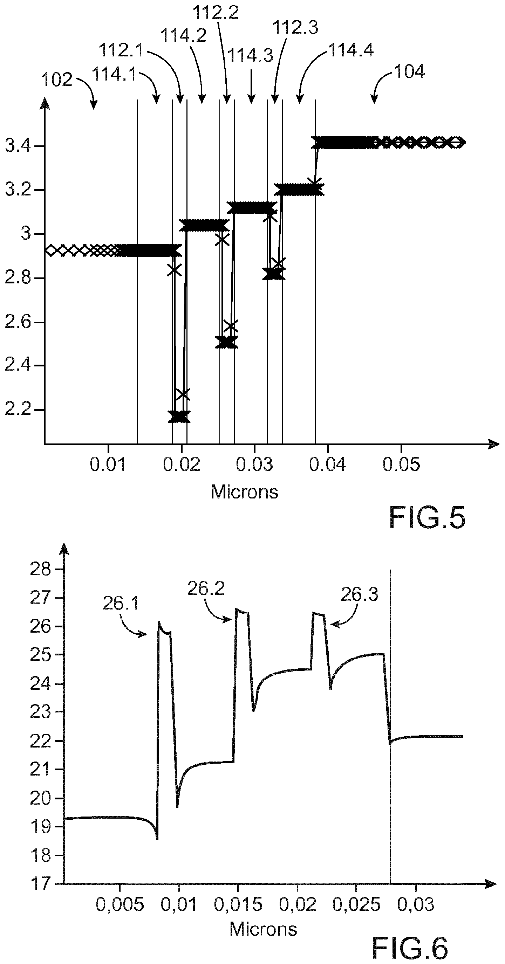

La figure 5 représente les gaps obtenus au sein des différentes couches de la LED 100. Trois « creux » similaires à ceux représentés sur la figure 2 correspondent aux gaps dans les trois couches émissives 112.1, 112.2 et 112.3 de la LED 100. Par contre, compte tenu des différentes compositions d'indium des matériaux des couches barrières 114.1 à 114.4 de la LED 100, on voit sur cette figure 5 que les gaps, au sein des différentes couches barrières 114.1 à 114.4, sont différents pour chacune des couches barrières 114.1 à 114.4.

La figure 6 représente le taux de recombinaisons radiatives, en échelle logarithmique et par cm³.s, obtenu dans les couches de la LED 100, pour une densité de courant d'environ 60 A/cm² obtenue avec une tension de seuil d'environ 3,4 V appliquée entre l'anode et la cathode de la LED 100. Ainsi, une densité de courant de valeur similaire à celle précédemment obtenue dans l'autre LED est obtenue dans la LED 100 avec une tension de seuil inférieure à celle nécessaire dans l'autre LED pour obtenir cette densité de courant, et cela grâce aux différentes compositions d'indium dans les couches barrières 114 de la LED 100.

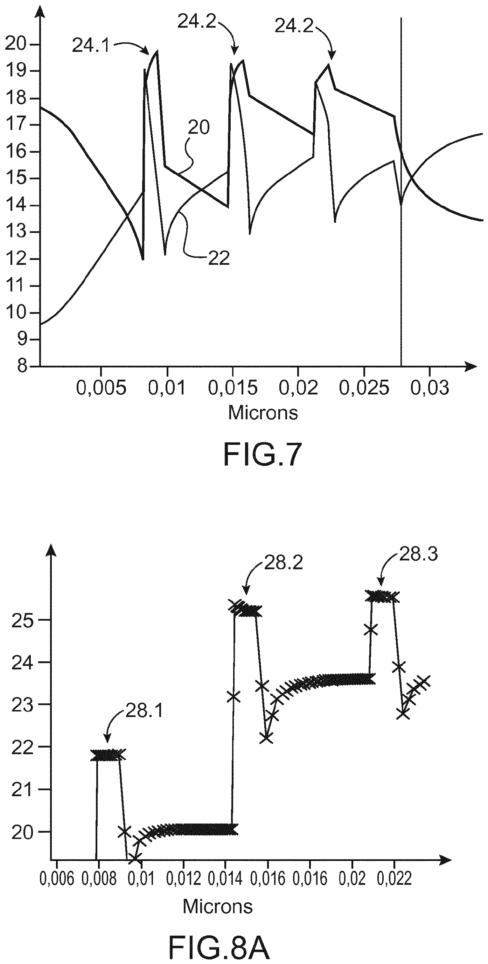

Comme précédemment, le taux de recombinaisons radiatives est fonction notamment des concentrations d'électrons et de trous au sein des couches de la LED 100. La figure 7 représente les concentrations en électrons (représentée par la courbe 20) et en trous (représentée par la courbe 22), par cm³, obtenues dans les différentes couches de la LED 100 polarisée comme précédemment avec une tension d'environ 3,4 V.

La courbe 20 représentée sur la figure 7 présente trois pics de valeurs comprises entre environ 10¹⁹ et 10²⁰ trous/cm³, correspondant aux concentrations de trous présents dans les trois couches émissives 112.1 à 112.3 de la LED 100. La répartition des trous dans les couches émissives de la LED 100 est donc relativement homogène. La courbe 22 représentée sur la figure 7 présente également trois pics correspondant aux concentrations d'électrons dans les trois couches émissives de la LED 100. Contrairement aux concentrations d'électrons inhomogènes obtenues dans les différentes couches émissives de l'autre LED, on voit que la courbe 22 comporte trois pics 24.1, 24.2 et 24.3 de valeurs proches (approximativement égales à environ 10¹⁹ électrons/cm³) se superposant globalement aux trois pics de la courbe 20, ces trois pics 24.1, 24.2 et 24.3 correspondant aux concentrations d'électrons dans les trois couches émissives 112.1 à 112.3 de la LED 100. Cela se traduit sur la figure 6 par des taux de recombinaisons radiatives de valeurs proches (comprises entre environ 10²⁶ et 10²⁷ cm⁻³.s⁻¹) dans les trois couches émissives (correspondant aux pics référencés 26.1, 26.2 et 26.3), ce qui signifie que les émissions lumineuses dans le rouge, le vert et le bleu réalisées par les puits quantiques de la LED 100 sont homogènes, c'est-à-dire d'intensités sensiblement similaires. Ainsi, grâce aux couches barrières 114 de la LED 100 comportant des compositions en indium judicieusement choisies, l'émission lumineuse réalisée par les différents puits quantiques de la LED 100 est homogène, ce qui permet à la LED 100 de réaliser une émission de lumière blanche.

Dans le mode de réalisation précédemment décrit, la couche 102 comporte du GaN-n ou de l'InGaN-n, c'est-à-dire une composition en indium (nulle ou non) constante le long de l'épaisseur de la couche dopée n 102.

En variante, la composition en indium de la couche dopée n 102 peut varier, par exemple de manière linéaire, dans le sens de l'épaisseur de la couche dopée n 102, formant ainsi un gradient dans la composition en indium du matériau de la couche dopée n 102 le long de l'épaisseur de la couche dopée n 102. En considérant la composition en indium Xn de la couche dopée n 102, la valeur de Xn peut varier entre une première valeur Xnₐ, correspondant à la valeur de la composition en indium de la couche dopée n 102 au niveau de sa deuxième face 111, et une deuxième valeur Xn_{b}, correspondant à la valeur de la composition en indium de la couche dopée n 102 au niveau de sa première face 109, telles que la deuxième valeur Xn_{b} soit supérieure à la première valeur Xnₐ. La première valeur Xnₐ est par exemple nulle, la couche dopée n 102 comportant dans ce cas du GaN au niveau de sa deuxième face 111, et la deuxième valeur Xn_{b} est par exemple égale à la composition en indium de la première couche barrière 114.1. Une telle couche dopée n 102 permet de passer progressivement du GaN ne comportant pas d'indium à de l'InGaN dont la composition en indium correspond à celle du matériau de la première couche barrière 114.1. Selon une variante avantageuse, le gradient de la composition en indium au sein de la couche dopée n 102 peut être tel que la deuxième valeur Xn_{b} soit inférieure à la première valeur Xnₐ, avec par exemple dans ce cas Xn_{b} < Xnₐ < 2.Xn_{b}. Selon une autre variante, il est possible d'avoir une couche tampon disposée entre la couche dopée n 102 et la première couche barrière 114.1 et qui comporterait de l'InGaN avec un tel gradient de sa composition d'indium. Dans le mode de réalisation précédemment décrit, chacune des couches barrières 114 comporte une composition en indium constante le long de l'épaisseur de chacune de ces couches barrières. En variante, une ou plusieurs de ces couches barrières 114 peut comporter une composition en indium variant, par exemple de manière linéaire, dans le sens de l'épaisseur de cette ou de ces couches barrières 114, formant ainsi un gradient dans la composition en indium du matériau de cette ou de chacune de ces couches barrières 114 le long de l'épaisseur de cette ou de ces couches barrières 114. En considérant la composition en indium Zj dans chacune des couches barrières 114, avec j nombre entier compris entre 1 et m+1, la valeur de Zj peut varier entre une première valeur Zjₐ et une deuxième valeur Zj_{b} supérieure à la première valeur Zjₐ selon une direction sensiblement perpendiculaire à une face de ladite couche barrière 114 contre laquelle l'une des couches émissives 106 est disposée, la composition en indium au niveau d'une première face de ladite couche barrière 114 se trouvant du côté la couche dopé n 102 étant égale à Zj_{b}, la composition en indium au niveau d'une deuxième face de ladite couche barrière 114, opposée à ladite première face et se trouvant du côté la couche dopée p 104 étant égale à Zjₐ. Pour de telles couches barrières 114, la différence entre la première valeur Zjₐ et la deuxième valeur Zjb est de préférence inférieure ou égale à environ 0,3.

Dans les exemples précédemment décrits, le choix des longueurs d'ondes émises par les couches émissives de la LED 100 est réalisé via le choix des compositions en indium au sein des couches émissives. De manière complémentaire, il est possible d'ajuster le spectre lumineux global émis par la LED 100, c'est-à-dire le spectre de la lumière émise en sortie de la LED 100, en faisant émettre les différentes couches émissives de la LED 100 avec plus ou moins d'intensité via le choix des paramètres du signal périodique alimentant électriquement la LED 100.

En effet, en faisant varier la densité de courant traversant la LED 100, il est possible de faire varier les taux de recombinaisons radiatives au sein des différentes couches émissives de la LED 100.

La figure 8A représente le taux de recombinaisons radiatives, en échelle logarithmique et par cm³.s, obtenu dans les couches de la LED 100, pour une densité de courant d'environ 10 A/cm² dans la LED 100. On voit sur cette figure que le taux de recombinaisons radiatives obtenu dans la troisième couche émissive 112.3 (correspondant au pic 28.3), qui émet une lumière bleue, est supérieur à celui obtenu dans la deuxième couche émissive 112.2 (correspondant au pic 28.2), qui émet une lumière verte, et également très supérieur à celui obtenu dans la première couche émissive 112.1 (correspondant au pic 28.1) qui émet une lumière rouge. Ainsi, avec une telle densité de courant d'environ 10 A/cm² traversant la LED 100, le spectre de la lumière obtenue en sortie de la LED 100 tendra vers celui d'une lumière bleue.

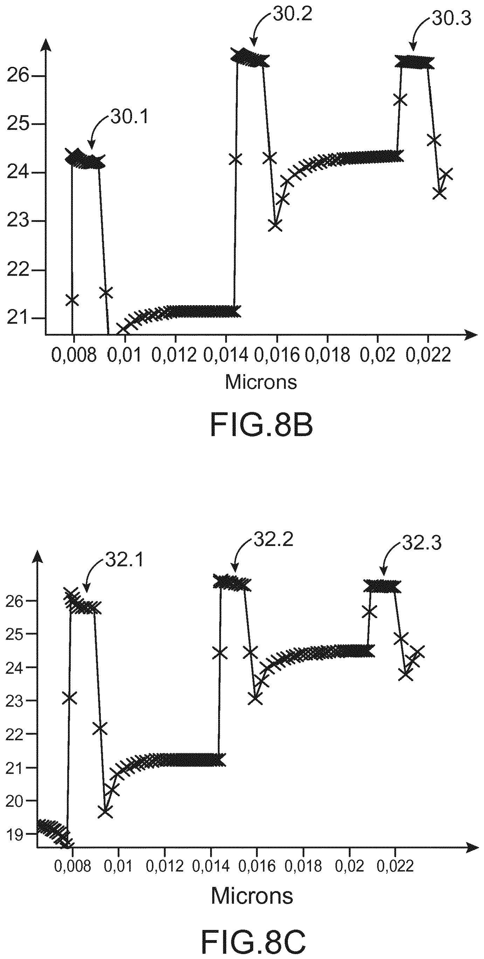

La figure 8B représente le taux de recombinaisons radiatives, en échelle logarithmique et par cm³.s, obtenu dans les couches de la LED 100, pour une densité de courant d'environ 50 A/cm² dans la LED 100. On voit sur cette figure que le taux de recombinaisons radiatives obtenu dans la deuxième couche émissive 112.2 (correspondant au pic 30.2) est cette fois supérieur à celui obtenu dans la troisième couche émissive 112.3 (correspondant au pic 30.3), et également très supérieur à celui obtenu dans la première couche émissive 112.1 (correspondant au pic 28.1). Ainsi, avec une telle densité de courant d'environ 50 A/cm² traversant la LED 100, le spectre de la lumière obtenue en sortie de la LED 100 tendra vers celui d'une lumière verte.

La figure 8C représente le taux de recombinaisons radiatives, en échelle logarithmique et par cm³.s, obtenu dans les couches de la LED 100, pour une densité de courant d'environ 80 A/cm² dans la LED 100. On voit sur cette figure que le taux de recombinaisons radiatives obtenu dans la première couche émissive 112.1 (correspondant au pic 32.1) est sensiblement similaire à celui obtenu dans la deuxième couche émissive 112.2 (correspondant au pic 32.2), et également sensiblement similaire à celui obtenu dans la troisième couche émissive 112.3 (correspondant au pic 32.3). Ainsi, avec une telle densité de courant d'environ 80 A/cm² traversant la LED 100, le spectre de la lumière obtenue en sortie de la LED 100 tendra vers celui d'une lumière blanche du fait que les émissions lumineuses réalisées par les trois couches émissives 112.1, 112.2 et 112.3 sont sensiblement équivalentes en termes d'intensité d'émission.

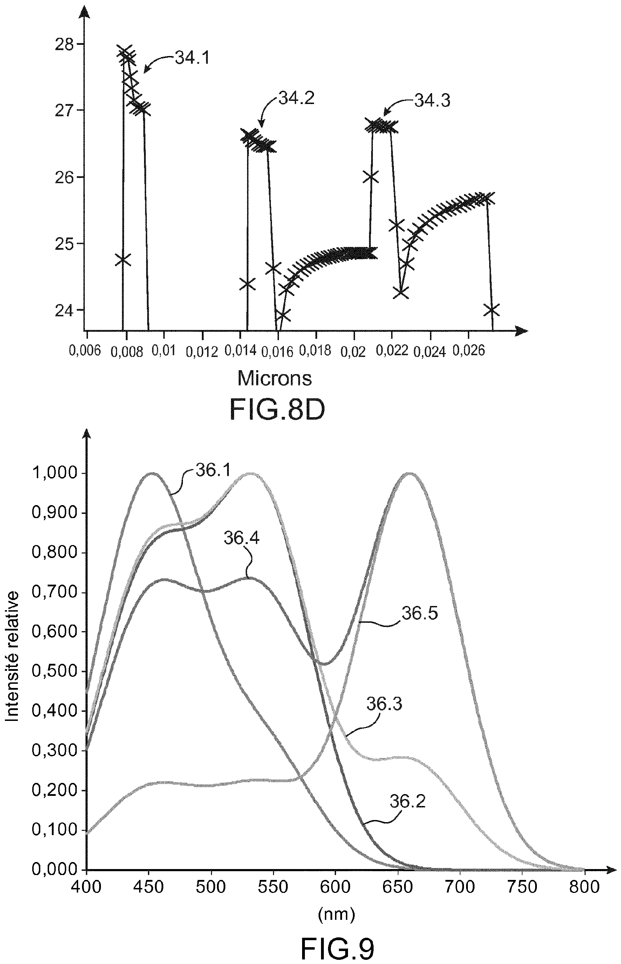

La figure 8D représente le taux de recombinaisons radiatives, en échelle logarithmique et par cm³.s, obtenu dans les couches de la LED 100, pour une densité de courant d'environ 140 A/cm² dans la LED 100. On voit sur cette figure que le taux de recombinaisons radiatives obtenu dans la première couche émissive 112.1 (correspondant au pic 34.1) est supérieur à celui obtenu dans la deuxième couche émissive 112.2 (correspondant au pic 34.2), et également supérieur à celui obtenu dans la troisième couche émissive 112.3 (correspondant au pic 34.3). Ainsi, avec une telle densité de courant d'environ 140 A/cm² traversant la LED 100, le spectre de la lumière obtenue en sortie de la LED 100 tendra vers celui d'une lumière rouge.

La figure 9 représente l'intensité lumineuse relative (sur une échelle variant de 0 à 1) obtenue pour différentes valeurs de la densité de courant du signal d'alimentation électrique de la LED 100, en fonction de la longueur d'onde (en nm). La courbe 36.1 correspond à une densité de courant égale à environ 10 A/cm², la courbe 36.2 correspond à une densité de courant égale à environ 50 A/cm², la courbe 36.3 correspond à une densité de courant égale à environ 60 A/cm², la courbe 36.4 correspond à une densité de courant égale à environ 90 A/cm², et la courbe 36.5 correspond à une densité de courant égale à environ 140 A/cm².

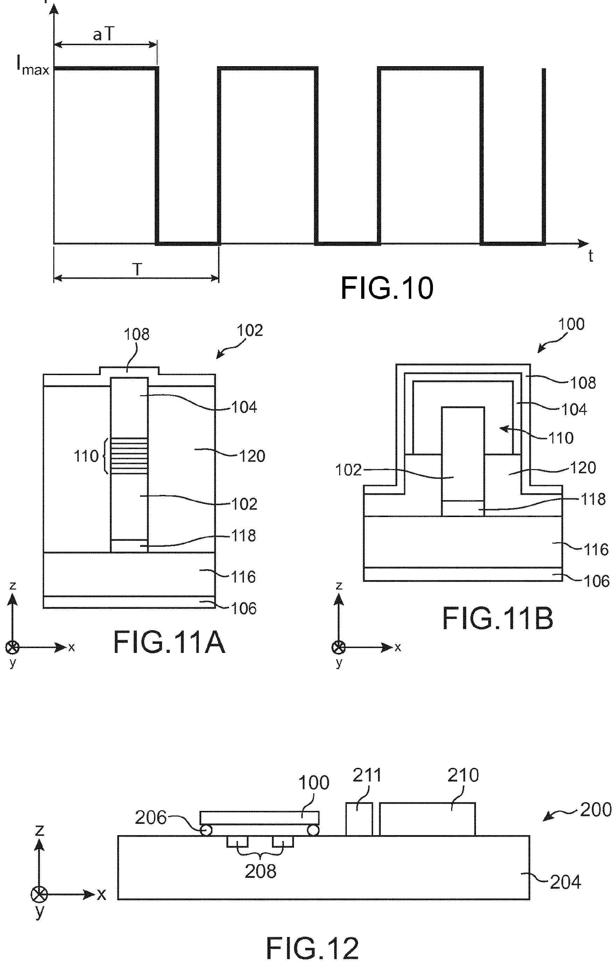

Du fait que la LED 100 est alimenté par un signal périodique (courant ou tension) correspondant par exemple à un signal carré tel que celui représenté sur la figure 10 qui correspond à un courant comportant une valeur crête Iₘₐₓ, une période T et un rapport cyclique a, il est possible de faire varier la valeur de la densité de courant traversant la LED 100, et donc la couleur de la lumière émise en sortie de la LED 100, en faisant varier la valeur crête Iₘₐₓ du signal d'alimentation de la LED 100. Le fait de faire varier la densité de courant traversant la LED 100 va faire également varier l'intensité de la lumière émise par la LED 100. Si l'on souhaite que le changement de couleur de la lumière émise par la LED 100 réalisé en faisant varier la densité de courant traversant la LED 100 n'impact pas l'intensité d'émission lumineuse de la LED 100, il est possible de faire varier également la valeur du rapport cyclique α du signal d'alimentation électrique de la LED 100. En effet, en faisant varier la valeur de ce rapport cyclique a, on fait également varier la durée pendant laquelle la LED 100 émettra de la lumière sur chaque période du signal d'alimentation électrique, et donc fera varier l'intensité de la lumière émise par la LED 100.

Ainsi, dans les exemples précédemment décrits, une émission d'une lumière de couleur bleue (cas de la figure 8A) est par exemple obtenue en choisissant un rapport cyclique α = 1 et en choisissant une valeur crête Iₘₐₓ telle que la densité de courant dans la LED 100 soit égale à environ 10 A/cm². Si l'on souhaite réaliser une émission d'une lumière de couleur verte (cas de la figure 8B) avec une intensité lumineuse sensiblement égale à celle obtenue lors de la précédente émission lumineuse de couleur bleue, la valeur crête Iₘₐₓ est modifiée afin que la LED 100 soit traversée par une densité de courant sensiblement égale à environ 50 A/cm², et le rapport cyclique α est choisi égal à environ 0,2 (10/50 = 0,2). Si l'on souhaite réaliser une émission d'une lumière de couleur blanche (cas de la figure 8C) avec une intensité lumineuse sensiblement égale à celle obtenue lors de la précédente émission lumineuse de couleur bleue, la valeur crête Iₘₐₓ est modifiée afin que la LED 100 soit traversée par une densité de courant sensiblement égale à environ 80 A/cm², et le rapport cyclique α est choisi égal à environ 0,125 (10/80 = 0,125). Enfin, si l'on souhaite réaliser une émission d'une lumière de couleur rouge (cas de la figure 8D) avec une intensité lumineuse sensiblement égale à celle obtenue lors de la précédente émission lumineuse de couleur bleue, la valeur crête Iₘₐₓ est modifiée afin que la LED 100 soit traversée par un courant d'alimentation dont la densité de courant est sensiblement égale à environ 140 A/cm², et le rapport cyclique α est choisi égal à environ 0,07 (10/140 = 0,07).

La LED 100 peut être réalisée sous la forme d'une diode planaire comme représenté sur la figure 1, c'est-à-dire sous la forme d'un empilement de couches formées sur un substrat (le substrat n'étant pas représenté sur la figure 1), les faces principales des différentes couches étant disposées parallèlement au plan du substrat (parallèles au plan (X,Y)). Les couches de GaN et d'InGaN d'une telle diode planaire peuvent être réalisées sur un substrat saphir, par exemple par MOCVD (« MetalOrganic Chemical Vapour Déposition » en anglais). Les électrodes métalliques 106 et 108 peuvent ensuite être réalisées par des dépôts métalliques de chaque côté de cet empilement de couches.

En variante, la LED 100 peut être réalisée sous la forme d'un nanofil. La figure 11A représente une telle LED 100 réalisée sous la forme d'un nanofil axial, ce nanofil comportant un empilement formé de la première électrode métallique 106, d'un substrat 116 de semi-conducteur (par exemple du gallium) de type n, d'une couche de nucléation 118 permettant la croissance du nanofil, de la couche 102 d'InGaN-n, de la zone active 110, de la couche 104 de GaN-p ou d'InGaN-p, et de la deuxième électrode 108. Un matériau isolant 120 peut entourer au moins une partie de ce nanofil qui s'étend parallèlement à l'axe Z.

La figure 11B représente une LED 100 réalisée sous la forme d'un nanofil radial, ce nanofil comportant un empilement formé de la première électrode 106, du substrat 116, de la couche de nucléation 118 et de la couche 102 dopée n. Des portions isolantes 120 entourent en partie la couche 102 dopée n et la couche de nucléation 118. La zone active 110 (formée des couches barrières 114 et des couches émissives 112) est réalisée telle qu'elle entoure au moins une partie de la couche 102. La couche 104 dopée p est réalisée telle qu'elle entoure la zone active 110. Enfin, la deuxième électrode 108 est réalisée en recouvrant la couche 104 dopée p.

En variante des deux exemples de réalisation décrits sur les figures 11A et 11B, la structure de ces nanofils peut être inversée, avec dans ce cas un substrat 124 de semi-conducteur, par exemple de gallium, dopé p sur lequel est réalisée la couche 104 dopée p, puis les autres éléments de la LED 100 dans l'ordre inverse de celui décrit sur les figures 11A et 11B.

De telles structures de nanofils peuvent être obtenues par croissance MOCVD.

Les différentes caractéristiques (épaisseurs, dopage, etc.) précédemment exposées pour la LED 100 de type planaire peuvent être similaires pour la LED 100 réalisée sous la forme de nanofils.

La figure 12 représente schématiquement un dispositif émissif lumineux 200 selon un mode de réalisation particulier.

Le dispositif émissif lumineux 200 comporte une LED 100 telle que précédemment décrite. La LED 100 est couplée mécaniquement et électriquement sur un substrat 204, par exemple en silicium, via des billes de matériau fusible 206. En variante, la LED 100 pourrait être réalisée directement par croissance sur le substrat 204. La LED 100 est ici apte à émettre à la fois depuis une face arrière se trouvant en regard du substrat 204 et depuis une face avant opposée à la face arrière.

Le dispositif émissif lumineux 200 comporte un dispositif de détection de la valeur d'un spectre et d'une intensité de la lumière émise par la LED 100 comportant ici deux photodiodes 208 réalisées dans le substrat 204, et qui sont disposées en regard de la face arrière de la LED 100. Une première des deux photodiodes 208 détecte les longueurs d'ondes inférieures à une première longueur d'onde de coupure appelée λ₁ et par exemple égale à environ 450 nm. Une deuxième des deux photodiodes 208 détecte les longueurs d'ondes supérieures à une deuxième longueur d'onde de coupure appelée λ₂ qui est telle que λ₂ > λ₁ et par exemple égale à environ 470 nm. La première longueur d'onde de coupure λ₁ est par exemple définie par un filtre passe-bas formée devant la première des deux photodiodes 208 (entre cette première photodiode et la LED 100) et la deuxième longueur d'onde de coupure λ₂ est par exemple définie par un filtre passe-haut formée devant la deuxième des deux photodiodes 208 (entre cette deuxième photodiode et la LED 100).

Le dispositif de détection de la valeur du spectre et de l'intensité de la lumière émise par la LED 100 comporte également des moyens de calcul (non représentés sur la figure 12) couplés aux photodiodes 208 et permettant de calculer, à partir de la somme des signaux électriques, ou photo-courants, délivrés par les photodiodes 208 l'intensité de la lumière, ou puissance lumineuse totale, émise par la LED 100. Ces moyens de calcul permettent également de calculer le spectre de la lumière émise par la LED 100 à partir du rapport entre les signaux électriques délivrés par les deux photodiodes 208.

En variante, la détection de la valeur du spectre et la détection de l'intensité de la lumière émise par la LED 100 pourraient être réalisées par deux dispositifs distincts.

Le dispositif émissif lumineux 200 comporte également une alimentation électrique 210, par exemple à découpage, permettant d'alimenter électriquement la LED 100. Cette alimentation 210 délivre une tension ou un courant sous la forme d'un signal périodique, par exemple un signal carré tel que celui représenté sur la figure 10, de période T et dont une valeur crête Imax ou Umax et un rapport de cycle α sont ajustables, le rapport cyclique α étant tel que *α* ∈ ]0;1].

Ces paramètres du signal électrique délivré par l'alimentation 210 sont commandés par un dispositif de commande 211 recevant en entrée les valeurs détectées du spectre et de l'intensité de la lumière émise par la LED 100 et délivrant en sortie un signal de commande envoyé à l'alimentation 210 (en variante, il est possible que le dispositif de commande 211 et l'alimentation électrique 210 forment un seul élément). Ces éléments forment une boucle de rétroaction telle que la valeur crête Imax ou Umax et le rapport cyclique α du signal délivré par l'alimentation 210 soient fonction du spectre et de l'intensité souhaitées pour la lumière destinée à être émise par la LED 100. Ainsi, pour ajuster l'intensité et le spectre de la lumière émise par la LED 100, la valeur crête et le rapport de cycle du signal d'alimentation sont ajustés pour que la somme et le rapport des photo-courants délivrés par les photodiodes 208 soient de valeurs égales à celles obtenues pour une intensité et un spectre souhaités (ces valeurs cibles de la somme et du rapport des photo-courants sont connues ou déterminées au préalable avec une LED servant de référence). Lorsque la détection du spectre et la détection de l'intensité lumineuse sont réalisées par deux dispositifs distincts, ces deux dispositifs peuvent être couplés optiquement à la LED 100 et reliés électriquement au dispositif de commande 211 en formant deux boucles de rétroaction.

Le dispositif de détection du dispositif émissif lumineux 200 peut être réalisé de manière intégré au substrat comme décrit par exemple dans le document US 2009/0040755 A1.

Grâce au dispositif de détection de la valeur du spectre de la lumière émise par la LED 100 qui est formé par les deux photodiodes 208 du dispositif émissif lumineux 200 précédemment décrit, ce dispositif de détection étant relié au dispositif de commande 211 lui-même relié à l'alimentation 210 en formant une boucle de rétroaction, le spectre de la lumière émise par la LED 100 est donc ajusté via l'ajustement de la valeur crête du signal d'alimentation électrique de la LED 100, par exemple ici l'ajustement de la valeur Imax du courant délivré par l'alimentation 210 (la densité de courant traversant le LED 100 étant fonction de cette valeur Imax), qui s'effectue en fonction du spectre d'émission souhaité. Ainsi, si les photodiodes 208 détectent que la LED 100 émet une longueur d'onde de valeur trop grande, le dispositif de commande 211 recevant en entrée les signaux délivrés par les photodiodes 208 commande alors à l'alimentation électrique à découpage 210 de délivrer en sortie un courant de plus forte amplitude. Inversement, si les photodiodes 208 détectent que la LED 100 émet une lumière de longueur d'onde trop basse, le dispositif de commande 211 commande alors à l'alimentation électrique 210 de délivrer en sortie un courant de plus faible amplitude.

La modification de la valeur crête du signal d'alimentation électrique de la LED 100, et donc de la densité de courant traversant la LED 100, impacte la longueur d'onde émise par la LED 100 mais également l'intensité de la lumière émise par la LED 100. Afin d'éviter que l'intensité lumineuse émise par la LED 100 ne soit impactée par la modification de la densité de courant traversant la LED 100 réalisée pour ajuster la longueur d'onde émise, cette intensité lumineuse d'émission de la LED 100 est ajustée au niveau souhaité via l'ajustement du rapport cyclique α du signal périodique d'alimentation électrique de la LED 100.

En effet, en alimentant la LED 100 avec une tension ou un courant sous la forme d'un signal carré périodique comportant un rapport cyclique α (qui est égal au rapport de la durée pendant laquelle, au cours d'une période T, le courant est égal à la valeur crête, sur la durée totale de la période T), l'intensité de la lumière émise par la LED 100 sera dépendante de la valeur crête mais également de la valeur de a.

La période T du signal périodique d'alimentation électrique de la LED 100 est choisie suffisamment petite pour ne pas observer de scintillement ou de clignotement de la LED 100, et correspondant par exemple à une fréquence comprise entre environ 20 Hz et 1 MHz.

Ainsi, si le dispositif de détection de l'intensité de la lumière émise par la LED 100 détecte une trop forte intensité, le dispositif de commande 211 recevant en entrée le signal délivré par ce dispositif de détection commande alors à l'alimentation électrique 210 de délivrer le courant de sortie avec un plus petit rapport cyclique a. Inversement, si le dispositif de détection de l'intensité de la lumière émise par la LED 100 détecte que la LED 100 émet une lumière avec une trop faible intensité, le dispositif de commande 211 commande alors à l'alimentation électrique 210 de délivrer le courant de sortie avec un plus grand rapport cyclique a.

## Revendications

1. Dispositif émissif lumineux (200) comportant au moins :
- une diode électroluminescente (100) comportant au moins une couche d'In_{Xn}Ga_{(1-Xn)}N dopé n (102) et une couche de GaN dopé p (104) formant ensemble une jonction p-n, et une zone active (110) disposée entre la couche d'In_{Xn}Ga_{(1-Xn)}N dopé n (102) et la couche de GaN dopé p (104) et comprenant m couches émissives d'In_{Yi}Ga_{(1-Yi)}N (112, 112.1 - 112.3) chacune disposée entre deux couches barrières d'In_{Zj}Ga_{(1-Zj)}N (114, 114.1 - 114.4) qui sont en contact avec ladite couche émissive (112, 112.1 - 112.3) au niveau de deux faces opposées de ladite couche émissive (112, 112.1 - 112.3), dans laquelle :
• pour i compris entre 1 et m-1, les compositions en indium des couches émissives (112, 112.1 - 112.3) sont telles que Y(i+1) < Yi, la (i+1)^{ème} couche émissive (112, 112.1 - 112.3) étant disposée entre la (i)^{ème} couche émissive (112, 112.1 - 112.3) et la couche de GaN dopé p (104) ;
• pour j compris entre 1 et m, les compositions en indium des couches barrières (114, 114.1 - 114.4) sont telles que Z(j+1) < Zj, la (j+1)^{ème} couche barrière (114, 114.1 - 114.4) étant disposée entre la (j)^{ème} couche barrière (114, 114.1 - 114.4) et la couche de GaN dopé p (104) ;
• pour i = j, les compositions en indium des couches émissives (112, 112.1 - 112.3) et des couches barrières (114, 114.1 - 114.4) sont telles que Zj < Yi et Z(j+1) < Yi ;
avec m : nombre entier supérieur ou égal à 2 ;
i : nombre entier compris entre 1 et m ;
j : nombre entier compris entre 1 et (m+1) ;
- une alimentation électrique (210) apte à alimenter électriquement la diode électroluminescente (100) par un signal périodique,
- un dispositif (211) de commande de l'alimentation électrique (210) apte à modifier une valeur crête du signal périodique en fonction d'au moins un spectre de la lumière destinée à être émise par la diode électroluminescente (100),
et dans lequel les compositions en indium Yi et/ou Zj sont telles que :
pour i = j : 0,15.Yi < Zj < 0,9.Yi, et/ou
pour j compris entre 1 et m : 0,25.Zj < Z(j+1) < 0,9.Zj.

2. Dispositif émissif lumineux (200) selon la revendication 1, dans lequel les couches barrières (114, 114.1 - 114.4) ont chacune une épaisseur comprise entre environ 1 nm et 25 nm, et/ou la première couche barrière d'In_{Z1}Ga_{(1-Z1)}N (114.1) a une épaisseur supérieure ou égale à 2 nm.

3. Dispositif émissif lumineux (200) selon l'une des revendications précédentes, dans lequel le nombre m de couches émissives (112, 112.1 - 112.3) est égal à 3, la première couche émissive (112.1) étant apte à réaliser une émission lumineuse dans la gamme des longueurs d'ondes de la couleur rouge, la deuxième couche émissive (112.2) étant apte à réaliser une émission lumineuse dans la gamme des longueurs d'ondes de la couleur verte, et la troisième couche émissive (112.3) étant apte à réaliser une émission lumineuse dans la gamme des longueurs d'ondes de la couleur bleue.

4. Dispositif émissif lumineux (200) selon l'une des revendications précédentes, dans lequel le nombre m de couches émissives (112, 112.1 - 112.3) est égal à 3, et dans lequel Y1 est égale à environ 0,4, et/ou Y2 est égale à environ 0,25, et/ou Y3 est égale à environ 0,15, et/ou Z1 est égale à environ 0,12, et/ou Z2 est égale à environ 0,09, et/ou Z3 est égale à environ 0,07, et/ou Z4 est égale à environ 0,05.

5. Dispositif émissif lumineux (200) selon l'une des revendications précédentes, dans lequel la composition en indium Xn est comprise entre 0 et environ 0,3, et/ou dans lequel la composition en indium Xn varie entre une première valeur Xnₐ et une deuxième valeur Xn_{b} supérieure à la première valeur Xnₐ selon une direction sensiblement perpendiculaire à une première face (109) de la couche d'In_{Xn}Ga_{(1-Xn)}N dopé n (102) en regard de laquelle la première couche émissive (112.1) est disposée, et dans lequel la composition en indium au niveau de la première face (109) de la couche d'In_{Xn}Ga_{(1-Xn)}N dopé n (102) est égale à Xn_{b} et la composition en indium au niveau d'une deuxième face (111) de la couche d'In_{Xn}Ga_{(1-Xn)}N dopé n (102), opposée à la première face (109), est égale à Xnₐ.

6. Dispositif émissif lumineux (200) selon la revendication 5, dans lequel Xnₐ est égale à 0, et dans lequel Xn_{b} est supérieure à 0 et inférieure ou égale à environ 0,3.

7. Dispositif émissif lumineux (200) selon l'une des revendications précédentes, dans lequel la composition en indium Zj dans chacune des couches barrières (114, 114.1 - 114.4) varie entre une première valeur Zjₐ et une deuxième valeur Zj_{b} supérieure à la première valeur Zjₐ selon une direction sensiblement perpendiculaire à une face de ladite couche barrière (114, 114.1 - 114.4) contre laquelle l'une des couches émissives (112, 112.1 - 112.3) est disposée, la composition en indium au niveau d'une première face de ladite couche barrière (114, 114.1 - 114.4) se trouvant du côté de la couche d'In_{Xn}Ga_{(1-Xn)}N dopé n (102) étant égale à Zj_{b}, la composition en indium au niveau d'une deuxième face de ladite couche barrière (114, 114.1 - 114.4), opposée à ladite première face et se trouvant du côté de la couche de GaN dopé p (104) étant égale à Zjₐ.

8. Dispositif émissif lumineux (200) selon la revendication 7, dans lequel les compositions en indium Zj dans chacune des couches barrières (114, 114.1 - 114.4) sont telles que Zjₐ > Z(j+1)_{b} et/ou, pour chacune des couches barrières (114, 114.1 - 114.4), la différence entre la première valeur Zjₐ et la deuxième valeur Zj_{b} est inférieure ou égale à environ 0,3.

9. Dispositif émissif lumineux (200) selon l'une des revendications précédentes, dans lequel le signal périodique comprend un rapport cyclique a, et dans lequel le dispositif (211) de commande de l'alimentation électrique (210) est apte à modifier le rapport cyclique α du signal périodique en fonction d'une valeur de l'intensité de la lumière destinée à être émise par la diode électroluminescente (100).

10. Dispositif émissif lumineux (200) selon la revendication 9, comportant en outre un dispositif (208) de détection d'un spectre et/ou d'une intensité d'une lumière destinée à être émise par la diode électroluminescente (100), et dans lequel le dispositif (211) de commande de l'alimentation électrique (210) est apte à modifier la valeur crête et/ou le rapport cyclique α du signal périodique respectivement en fonction des valeurs du spectre et de l'intensité de la lumière destinée à être détectées et en fonction de valeurs cibles du spectre et de l'intensité.

11. Dispositif émissif lumineux (200) selon l'une des revendications précédentes, dans lequel le signal périodique est un signal carré.

12. Procédé de réalisation d'un dispositif émissif lumineux (200) selon l'une des revendications 1 à 11, dans lequel les couches (102, 104, 106, 108, 110) de la diode électroluminescente (100) sont des couches planaires réalisées par croissance les unes au-dessus des autres, ou dans lequel les couches (102, 104, 106, 108, 110) de la diode électroluminescente (100) sont réalisées par croissance sous la forme de nanofils radiaux ou axiaux.

## Patentansprüche

1. Lichtemittierende Vorrichtung (200), umfassend wenigstens Folgendes:
- eine Elektrolumineszenzdiode (100), umfassend wenigstens eine Schicht aus n-dotiertem In_{Xn}Ga_{(1-Xn)}N (102) und eine Schicht aus p-dotiertem GaN (104), die zusammen einen p-n-Übergang bilden, sowie eine aktive Zone (110), die zwischen der Schicht aus n-dotiertem In_{Xn}Ga_{(1-Xn)}N (102) und der Schicht aus p-dotiertem GaN (104) angeordnet ist und m emittierende Schichten aus In_{Yi}Ga_{(1-Yi)}N (112, 112.1-112.3) umfasst, die jeweils angeordnet sind zwischen zwei Barriereschichten aus In_{Zj}Ga_{(1-Zj)}N (114, 114.1-114.4), die in Kontakt mit der emittierenden Schicht (112, 112.1-112.3) im Bereich von zwei entgegengesetzten Flächen der emittierenden Schicht (112, 112.1-112.3) sind, wobei:
• für i enthalten zwischen 1 und m-1, die Indium-Zusammensetzungen der emittierenden Schichten (112, 112.1-112.3) derart sind, dass Y(i+1) < Yi, wobei die (i+1)-te emittierende Schicht (112, 112.1-112.3) angeordnet ist zwischen der (i)-ten emittierenden Schicht (112, 112.1-112.3) und der Schicht aus p-dotiertem GaN (104);
• für j enthalten zwischen 1 und m, die Indium-Zusammensetzungen der Barriereschichten (114, 114.1-114.4) derart sind, dass Z(j+1) < Zj, wobei die (j+1)-te Barriereschicht (114, 114.1-114.4) angeordnet ist zwischen der (j)-ten Barriereschicht (114, 114.1-114.4) und der Schicht aus p-dotiertem GaN (104);
• für i=j, die Indium-Zusammensetzungen der emittierenden Schichten (112, 112.1-112.3) und der Barriereschichten (114, 114.1-114.4) derart sind, dass Zj < Yi und Z(j+1) < Yi;
wobei m: ganze Zahl größer oder gleich 2;
i: ganze Zahl enthalten zwischen 1 und m;
j: ganze Zahl enthalten zwischen 1 und (m+1);
- eine elektrische Versorgung (210), die dazu ausgelegt ist, die Elektrolumineszenzdiode (100) elektrisch mit einem periodischen Signal zu versorgen;
- eine Vorrichtung (211) zur Steuerung der elektrischen Versorgung (201), die dazu ausgelegt ist, einen Spitzenwert des periodischen Signals als Funktion wenigstens eines Spektrums des Lichts zu modifizieren, das durch die Elektrolumineszenzdiode (100) emittiert werden soll,
und wobei die Indium-Zusammensetzungen Yi und/oder Zj derart sind, dass:
für i=j: 0,15.Yi < Zj < 0,9.Yi, und/oder
für j enthalten zwischen 1 und m: 0,25.Zj < Z(j+1) < 0.9.Zj.

2. Lichtemittierende Vorrichtung (200) nach Anspruch 1, bei der die Barriereschichten (114, 114.1-114.4) jeweils eine Dicke haben, die zwischen ungefähr 1 nm und 25 nm enthalten ist, und/oder wobei die erste Barriereschicht aus In_{Z1}Ga_{(1-Z1)}N (114.1) eine Dicke größer oder gleich 2 nm hat.

3. Lichtemittierende Vorrichtung (200) nach einem der vorhergehenden Ansprüche, bei der die Zahl m von emittierenden Schichten (112, 112.1-112.3) gleich 3 ist, wobei die erste emittierende Schicht (112.1) dazu ausgelegt ist, eine Lichtemission im Wellenlängenbereich der Farbe rot zu realisieren, wobei die zweite emittierende Schicht (112.2) dazu ausgelegt ist, eine Lichtemission im Wellenlängenbereich der Farbe grün zu realisieren, und wobei die dritte emittierende Schicht (112.3) dazu ausgelegt ist, eine Lichtemission im Wellenlängenbereich der Farbe blau zu realisieren.

4. Lichtemittierende Vorrichtung (200) nach einem der vorhergehenden Ansprüche, bei der die Zahl m von emittierenden Schichten (112, 112.1-112.3) gleich 3 ist, und bei der Y1 gleich ungefähr 0,4 ist, und/oder wobei Y2 gleich ungefähr 0,25 ist, und/oder wobei Y3 gleich ungefähr 0,15 ist, und/oder wobei Z1 gleich ungefähr 0,12 ist, und/oder wobei Z2 gleich ungefähr 0,09 ist, und/oder wobei Z3 gleich ungefähr 0,07 ist, und/oder wobei Z4 gleich ungefähr 0,05 ist.

5. Lichtemittierende Vorrichtung (200) nach einem der vorhergehenden Ansprüche, bei der die Indium-Zusammensetzung Xn zwischen 0 und ungefähr 0,3 enthalten ist, und/oder wobei die Indium-Zusammensetzung Xn variiert zwischen einem ersten Wert Xnₐ und einem zweiten Wert Xn_{b} größer als der erste Wert Xnₐ entlang einer Richtung, die im Wesentlichen orthogonal zu einer ersten Fläche (109) der Schicht aus n-dotiertem In_{Xn}Ga_{(1-Xn)}N ist, gegenüber der die erste emittierende Schicht (112.1) angeordnet ist, und wobei die Indium-Zusammensetzung im Bereich der ersten Fläche (109) der Schicht aus n-dotiertem In_{Xn}Ga_{(1-Xn)}N (102) gleich Xn_{b} ist, und die Indium-Zusammensetzung im Bereich einer zweiten Fläche (111) der Schicht aus n-dotiertem In_{Xn}Ga_{(1-Xn)}N (102), entgegengesetzt zur ersten Fläche (109), gleich Xnₐ ist.

6. Lichtemittierende Vorrichtung (200) nach Anspruch 5, bei der Xnₐ gleich 0 ist, und bei der Xn_{b} größer als 0 und kleiner oder gleich ungefähr 0,3 ist.

7. Lichtemittierende Vorrichtung (200) nach einem der vorhergehenden Ansprüche, bei der die Indium-Zusammensetzung Zj in jeder der Barriereschichten (114, 114.1-114.4) variiert zwischen einem ersten Wert Zjₐ und einem zweiten Wert Zj_{b} größer als der erste Wert Zjₐ entlang einer Richtung, die im Wesentlichen orthogonal zu einer Fläche der Barriereschicht (114, 114.1-114.4) ist, gegen die eine der emittierenden Schichten (112, 112.1-112.3) angeordnet ist, wobei die Indium-Zusammensetzung im Bereich einer ersten Fläche der Barriereschicht (114, 114.1-114.4), die sich neben der Schicht aus n-dotiertem In_{Xn}Ga_{(1-Xn)}N (102) befindet, gleich Zj_{b} ist, wobei die Indium-Zusammensetzung im Bereich einer zweiten Fläche der Barriereschicht (114, 114.1-114.4), die der ersten Fläche entgegengesetzt ist und sich neben der Schicht aus p-dotiertem GaN (104) befindet, gleich Zjₐ ist.

8. Lichtemittierende Vorrichtung (200) nach Anspruch 7, bei der die Indium-Zusammensetzungen Zj in jeder der Barriereschichten (114, 114.1-114.4) derart sind, dass Zjₐ > Z(j+1)_{b}, und/oder für jede der Barriereschichten (114, 114.1-114.4) die Differenz zwischen dem ersten Wert Zjₐ und dem zweiten Wert Zj_{b} kleiner oder gleich ungefähr 0,3 ist.

9. Lichtemittierende Vorrichtung (200) nach einem der vorhergehenden Ansprüche, bei der das periodische Signal ein Tastverhältnis *α* umfasst und bei der die Vorrichtung (211) zur Steuerung der elektrischen Versorgung (210) dazu ausgelegt ist, das Tastverhältnis *α* des periodischen Signals als Funktion eines Werts der Intensität des Lichts zu modifizieren, das durch die Elektrolumineszenzdiode (100) emittiert werden soll.

10. Lichtemittierende Vorrichtung (200) nach Anspruch 9, ferner umfassend eine Vorrichtung (208) zur Erfassung eines Spektrums und/oder einer Intensität eines Lichts, das durch die Elektrolumineszenzdiode (100) emittiert werden soll, und wobei die Vorrichtung (211) zur Steuerung der elektrischen Versorgung (210) dazu ausgelegt ist, den Spitzenwert und/oder das Tastverhältnis *α* des periodischen Signals als Funktion der Werte des Spektrums beziehungsweise der Intensität des Lichts zu modifizieren, das erfasst werden soll, sowie als Funktion der Zielwerte des Spektrums und der Intensität.

11. Lichtemittierende Vorrichtung (200) nach einem der vorhergehenden Ansprüche, bei der das periodische Signal ein Rechtecksignal ist.

12. Verfahren zur Herstellung einer lichtemittierenden Vorrichtung (200) nach einem der Ansprüche 1 bis 11, bei dem die Schichten (102, 104, 106, 108, 110) der Elektrolumineszenzdiode (100) planare Schichten sind, die durch Aufwachsen aufeinander realisiert sind, oder bei dem die Schichten (102, 104, 106, 108, 110) der Elektrolumineszenzdiode (100) durch Wachsen in Form von radialen oder axialen Nanodrähten realisiert sind.

## Claims

1. Light-emitting device (200) comprising at least:
- a light-emitting diode (100) comprising at least one n-doped In_{Xn}Ga_{(1-Xn)}N layer (102) and a p-doped GaN layer (104) forming together a p-n junction, and an active zone (110) arranged between the n-doped In_{Xn}Ga_{(1-Xn)}N layer (102) and the p-doped GaN layer (104) and comprising a number m of In_{Yi}Ga_{(1-Yi)}N-emitting layers (112, 112.1 - 112.3) each one arranged between two In_{Zj}Ga_{(1-Zj)}N barrier layers (114, 114.1 - 114.4) that are in contact with said emitting layer (112, 112.1 - 112.3) on the two opposite faces of said emitting layer (112, 112.1 - 112.3), wherein:
• for i between 1 and m-1, the indium compositions of the emitting layers (112, 112.1 - 112.3) are such that Y(i+1) < Yi, the (i+1)^{th} emitting layer (112, 112.1 - 112.3) being arranged between the (i)^{th} emitting layer (112, 112.1 - 112.3) and the p-doped GaN layer (104);
• for j between 1 and m, the indium compositions of the barrier layers (114, 114.1 - 114.4) are such that Z(j+1) < Zj, the (j+1)^{th} barrier layer (114, 114.1 - 114.4) being arranged between the (j)^{th} barrier layer (114, 114.1 - 114.4) and the p-doped GaN layer (104);
• for i = j, the indium compositions of the emitting layers (112, 112.1 - 112.3) and of the barrier layers (114, 114.1 - 114.4) are such that Zj < Yi and Z(j+1) < Yi;
with m: integer greater than or equal to 2;
i: integer between 1 and m;
j: integer between 1 and (m+1);
- an electric power supply (210) able to electrically power the light-emitting diode (100) with a periodic signal,
- a device (211) for controlling the electric power supply (210) which can alter the peak value of the periodic signal according to at least one spectrum of the light intended to be emitted by the light-emitting diode (100),
and wherein the indium compositions Yi and/or Zj are such that:
for i = j: 0.15 Yi < Zj < 0.9 Yi, and/or
for j between 1 and m: 0.25 Zj < Z(j+1) < 0.9 Zj.

2. Light-emitting device (200) according to claim 1, wherein the barrier layers (114, 114.1 - 114.4) each have a thickness between about 1 nm and 25 nm, and/or the first In_{Z1}Ga_{(1-Z1)}N barrier layer (114.1) has a thickness greater than or equal to 2 nm.

3. Light-emitting device (200) according to one of the preceding claims, wherein the number m of emitting layers (112, 112.1 - 112.3) is equal to 3, with the first emitting layer (112.1) able to carry out a light emission in the range of the wavelengths of the colour red, with the second emitting layer (112.2) able to carry out a light emission in the range of the wavelengths of the colour green, and the third emitting layer (112.3) able to carry out a light emission in the range of the wavelengths of the colour blue.

4. Light-emitting device (200) according to one of the preceding claims, wherein the number m of emitting layers (112, 112.1 - 112.3) is equal to 3, and wherein Y1 is equal to about 0.4, and/or Y2 is equal to about 0.25, and/or Y3 is equal to about 0.15, and/or Z1 is equal to about 0.12, and/or Z2 is equal to about 0.09, and/or Z3 is equal to about 0.07, and/or Z4 is equal to about 0.05.

5. Light-emitting device (200) according to one of the preceding claims, wherein the indium composition Xn is between 0 and about 0.3, and/or wherein the indium composition Xn varies between a first value Xnₐ and a second value Xn_{b} greater than the first value Xnₐ according to a direction substantially perpendicular to a first face (109) of the n-doped In_{Xn}Ga_{(1-Xn)}N layer (102) opposite which the first emitting layer (112.1) is arranged, and wherein the indium composition at the first face (109) of the n-doped In_{Xn}Ga_{(1-Xn)}N layer (102) is equal to Xn_{b} and the indium composition at a second face (111) of the n-doped In_{Xn}Ga_{(1-Xn)}N layer (102), opposite the first face (109), is equal to Xnₐ.

6. Light-emitting device (200) according to claim 5, wherein Xnₐ is equal to 0, and wherein Xn_{b} is greater than 0 and less than or equal to about 0.3.

7. Light-emitting device (200) according to one of the preceding claims, wherein the indium composition Zj in each one of the barrier layers (114, 114.1 - 114.4) varies between a first value Zjₐ and a second value Zj_{b} greater than the first value Zjₐ according to a direction substantially perpendicular to a face of said barrier layer (114, 114.1 - 114.4) against which one of the emitting layers (112, 112.1 - 112.3) is arranged, the indium composition at a first face of said barrier layer (114, 114.1 - 114.4) located on the side of the n-doped In_{Xn}Ga_{(1-Xn)}N layer (102) being equal to Zj_{b}, the indium composition at a second face of said barrier layer (114, 114.1 - 114.4), opposite said first face and located on the side of the p-doped GaN layer (104) being equal to Zjₐ.

8. Light-emitting device (200) according to claim 7, wherein the indium compositions Zj in each one of the barrier layers (114, 114.1 - 114.4) are such that Zjₐ > Z(j+1)_{b} and/or, for each one of the barrier layers (114, 114.1 - 114.4), the difference between the first value Zjₐ and the second value Zj_{b} is less than or equal to about 0.3.

9. Light-emitting device (200) according to one of the preceding claims, wherein the periodic signal comprises a duty cycle α, and wherein the device (211) for controlling the electric power supply (210) is able to modify the duty cycle α of the periodic signal according to a value of the intensity of the light intended to be emitted by the light-emitting diode (100).

10. Light-emitting device (200) according to claim 9, further comprising a device (208) for detecting a spectrum and/or an intensity of a light intended to be emitted by the light-emitting diode (100), and wherein the device (211) for controlling the electric power supply (210) is able to modify the peak value and/or the duty cycle α of the periodic signal respectively according to the values of the spectrum and of the intensity of the light intended to be detected and according to target values of the spectrum and of the intensity.

11. Light-emitting device (200) according to one of the preceding claims, wherein the periodic signal is a square signal.

12. Method for making a light-emitting device (200) according to one of claims 1 to 11, wherein the layers (102, 104, 106, 108, 110) of the light-emitting diode (100) are planar layers made by growth on top of one another, or wherein the layers (102, 104, 106, 108, 110) of the light-emitting diode (100) are made by growth in the form of radial or axial nanowires.
